# FASCICULE DE BREVET EUROPEEN

(11) **EP 4 239 674 B1**
(45) Date de publication et mention de la délivrance du brevet: **27.11.2024**
(21) Numéro de dépôt: 22216893.2
(22) Date de dépôt: 28.12.2022
(51) Int. Cl.: H02M 5/458, H01L 23/373

(54) **COMPOSANT DE PUISSANCE A FILTRAGE LOCAL ET CONVERTISSEUR METTANT EN OEUVRE PLUSIEURS COMPOSANTS DE PUISSANCE A FILTRAGE LOCAL**
LEISTUNGSBAUELEMENT MIT LOKALER FILTERUNG UND WANDLER MIT MEHREREN LEISTUNGSKOMPONENTEN MIT LOKALER FILTERUNG
POWER COMPONENT WITH LOCAL FILTERING AND CONVERTER USING SEVERAL POWER COMPONENTS WITH LOCAL FILTERING

(30) Priorité: 28.12.2021 FR 2114585
(43) Date de publication de la demande: 06.09.2023
(73) Titulaire: Safran Electrical & Power, 31700 Blagnac (FR)
(72) Inventeur: DUBOIS, Eric Ravindranath, 78400 Chatou (FR); KHERBOUCHI, Hocine, 78400 Chatou (FR); BERGER, Jean Paul, 78400 Chatou (FR); DEVAUTOUR, Joel, 78400 Chatou (FR)
(74) Mandataire: Atout PI Laplace

(56) Documents cités:
- EP-A1- 2 750 184
- DE-A1- 102013 210 146
- US-A1- 2020 161 207
- US-A1- 2021 210 477

## Description

### Contexte de l'invention

En électronique de puissance, de nombreux convertisseurs statiques ont été développés, principalement des onduleurs et des redresseurs. On trouve également des équipements plus complexes tels que des alimentations à découpage. Ces convertisseurs sont équipés de composants électroniques permettant commuter un signal électrique. Les composants de commutation sont souvent appelés : « interrupteurs électroniques ». Parmi ces composants, on peut citer les diodes, les transistors, les thyristors, les triacs...

Les diodes de puissance ont été développées à partir des années 1950. Dans les années 1960, les thyristors et les transistors de puissance apparaissent. Plus tard, dans les années 1980, apparaissent des transistors bipolaires à grille isolée connu par son acronyme anglais IGBT pour « Insulated Gate Bipolar Transistor ». Ce type de transistor combine l'avantage d'une commande au moyen d'un transistor à effet de champ et les faibles pertes par conduction d'un transistor bipolaire. A ce jour, les IGBT permettent de commuter des puissances de l'ordre de 10MW à des vitesses supérieures à 10kHz. Pour de plus faibles puissances, des transistors de type MOSFET sont également largement employés. Dans les années 2000, des composants, et notamment des transistors MOSFET, à base de carbure de silicium (SiC) apparaissent. Ils permettent d'atteindre des vitesses supérieures à 1 MHz. Plus récemment le nitrure de gallium GaN a également été introduit dans les transistors MOSFET pour réaliser des interrupteurs électroniques. Le nitrure de gallium permet de monter encore en vitesse de commutation à des fréquences supérieures à 10MHz.

En commutant des signaux électriques de puissance, ces composants génèrent des pertes thermiques qu'il est nécessaire d'évacuer. Le refroidissement des interrupteurs électroniques est le plus souvent réalisé au moyen de radiateurs permettant d'évacuer la chaleur par convection d'air circulant le long des parois du radiateur. Les radiateurs peuvent aussi être équipés de canaux dans lesquels circule un fluide réfrigérant.

Pour assurer un bon transfert thermique du composant vers son radiateur, il est nécessaire de réduire au maximum la résistance thermique du chemin parcouru par la chaleur depuis sa zone d'émission au coeur du composant jusqu'au radiateur permettant la dissipation de cette chaleur. L'interrupteur électronique dispose le plus souvent d'une semelle métallique disposée à proximité immédiate du coeur du composant et par laquelle transite la chaleur à évacuer. La semelle peut être isolée électriquement du composant ou former l'un de ses points de connexion. Lors du montage de l'interrupteur électronique, la semelle est plaquée contre le radiateur. Le contact de la semelle sur le radiateur peut être thermiquement amélioré au moyen d'une pâte thermiquement conductrice. Il est également possible d'interposer un isolant électrique entre la semelle et le radiateur sous forme de plaquette à base d'oxyde d'aluminium, de mica ou de silicone.

La sécurité des utilisateurs d'équipements mettant en oeuvre des interrupteurs électroniques nécessite généralement une mise à la masse électrique des radiateurs. Pour une meilleure dissipation de la chaleur, il est même possible d'utiliser le boîtier extérieur de l'équipement comme radiateur. Ceci impose d'autant plus de raccorder le boîtier à la masse électrique du système comprenant l'équipement.

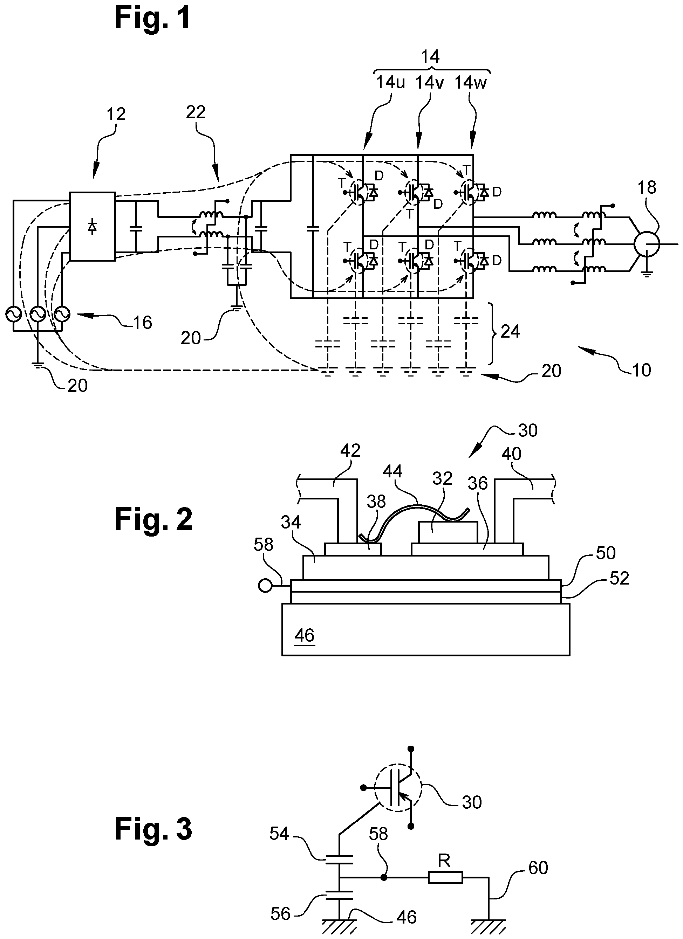

La figure 1 représente une architecture électrique 10 comprenant deux convertisseurs statiques : un redresseur 12 et un onduleur 14. L'architecture électrique 10 est bien adaptée à équiper un véhicule, notamment un aéronef. L'architecture électrique 10 comprend un réseau alternatif 16 permettant d'alimenter une charge 18, tel que par exemple un moteur au travers du redresseur 12, générant une tension continue à partir la tension alternative issue du réseau alternatif 16, et au travers de l'onduleur 14 fournissant une tension alternative à la charge 18 à partir de la tension continue.

Sur la figure 1, l'architecture électrique 10 est représentée de façon sommaire. En pratique, la tension continue peut former un réseau permettant d'alimenter un grand nombre de charges, chacune pouvant fonctionner avec une tension alternative différente. Il est possible d'adapter la fréquence de la tension alternative au besoin de la charge. On peut par exemple moduler la vitesse du moteur en faisant varier la fréquence au moyen de l'onduleur 14. Plusieurs onduleurs peuvent alimenter une même charge. L'architecture électrique 10 peut être reconfigurable en temps réel. Elle permet d'alimenter une charge au moyen d'autant de convertisseurs que nécessaire comme par exemple décrit dans la demande de brevet publiée sous le n° EP 2 887 519 et déposée au nom de la demanderesse. Le document US 2020/0161207 A1 décrit des adaptations pour un module de puissance à semi-conducteur permettant de réduire les capacités parasites et les interférences de mode commun.

Des perturbations de mode commun peuvent circuler dans l'architecture électrique 10. Ces perturbations représentées en pointillés épais sur la figure 1 circulent principalement au travers d'une masse électrique 20 de l'architecture électrique 10. Le réseau alternatif 16 étant relié à la masse 20, les perturbations se superposent aux tensions alternatives du réseau alternatif 16 puis aux tensions continues issues du redresseur 12.

A ce jour, les perturbations de mode commun sont limitées au moyen de filtres inductifs disposés par exemple sur le réseau continu. Comme illustré sur la figure 1, un filtre de mode commun 22 comprend deux inductances disposées sur un même noyau magnétique. Dans chacune des inductances circule une phase du réseau continu. Les inductances sont réalisées au moyen de conducteurs électriques enroulés sur le noyau magnétique commun. Les conducteurs électriques formant les inductances sont dimensionnés pour supporter le courant utile du réseau continu. De ce fait, les sections de conducteurs sont importantes. Le noyau magnétique sur lequel les conducteurs sont enroulés est également volumineux. Ceci entraine un poids et un volume important pour le filtre 22.

Par ailleurs, les interrupteurs électroniques des convertisseurs possèdent une capacité parasite 24 formée entre le canal de conduction de l'interrupteur, la semelle et le radiateur. Cette capacité 24 est due à la proximité entre le canal de conduction, la semelle et le radiateur, proximité rendue nécessaire pour l'évacuation de la chaleur dégagée lors des commutations.

Des expérimentations en internes ont montré que les perturbations de mode commun tendent à se propager au travers des capacités parasites 24 des interrupteurs électroniques pour atteindre la masse électrique 20. Sur la figure 1, seules les capacités parasites 24 des interrupteurs électroniques de l'onduleur 14 sont représentées. Les diodes du redresseur 12 peuvent posséder également le même type de capacité parasite, dès qu'une de leurs électrodes est disposée à proximité ou en contact avec une pièce mécanique reliée électriquement à la masse électrique 20. Les courants formant les perturbations de mode commun sont d'autant plus importants que la fréquence de commutation augmente. Avec la mise en oeuvre d'interrupteurs électroniques pouvant atteindre des temps de commutation extrêmement réduits, les courants de perturbation deviennent de plus en plus préoccupants. Du fait de leur volume et de leur masse, les solutions actuelles permettant de réduire les perturbations, notamment les courants de mode commun, sont difficiles à mettre en oeuvre avec les nouvelles générations d'interrupteurs électroniques.

### Résumé de l'invention

L'invention propose une solution à ces problèmes en filtrant à la source les courants pouvant transiter dans les capacités parasites des interrupteurs électroniques.

A cet effet, l'invention a pour objet un composant configuré pour commuter un signal électrique, le composant comprenant :
- un substrat isolant portant une puce semi-conductrice assurant la commutation du signal,
- une semelle sur laquelle est fixé le substrat, la semelle étant configurée pour évacuer de la chaleur émise lors de commutation du composant,
- un plan conducteur disposé entre la semelle et le substrat isolant, le plan conducteur étant isolé électriquement de la semelle,
- un composant spécifique présentant une impédance d'au moins 1 Ohm et/ou une inductance d'au moins 1 µH, par l'intermédiaire duquel le plan conducteur est raccordé à une tension de référence.

Avantageusement, le composant est une résistance d'au moins 1 Ohm.

L'invention a également pour objet un convertisseur statique comprenant plusieurs composants selon l'une des revendications précédentes dans lequel les plans conducteurs et les semelles de chaque composant sont commun.

Avantageusement, le convertisseur comprend un premier groupe et un second groupe de composants, dans chacun des groupes de composants, les plans conducteurs et les semelles de chaque composant sont commun, le plan conducteur du premier groupe est raccordé à une première tension de référence par l'intermédiaire d'une première inductance et le plan conducteur du second groupe est raccordé à une seconde tension de référence par l'intermédiaire d'une seconde inductance, et les deux inductances sont couplées et ont une impédance d'au moins 1 µH.

### Brève description des figures

L'invention sera mieux comprise et d'autres avantages apparaîtront à la lecture de la description détaillée d'un mode de réalisation donné à titre d'exemple, description illustrée par le dessin joint dans lequel :
la figure 1, déjà décrite, représente une architecture électrique dans laquelle l'invention peut être mise en oeuvre ;
la figure 2 représente un composant de commutation conforme à l'invention ;
la figure 3 représente un schéma équivalent du composant de la figure 1 ;
la figure 4 représente plusieurs composant de commutation d'un convertisseur statique conforme à l'invention ;
la figure 5 représente schématiquement un convertisseur statique conforme à l'invention.

Par souci de clarté, les mêmes éléments porteront les mêmes repères dans les différentes figures.

### Description détaillée de l'invention

La figure 2 représente en coupe un composant de commutation 30 mettant en oeuvre une puce active 32 à base de semi-conducteur. Tout type de composant de commutation peut être mis en oeuvre dans le cadre de l'invention. Le composant peut être à commutation naturelle comme une diode ou à commutation commandée tel qu'un thyristor ou un transistor. A ce jour, de nombreux matériaux sont mis en oeuvre pour réaliser des composants de commutation, notamment le silicium, le germanium, l'arséniure de gallium, le carbure de silicium, le nitrure de gallium. L'invention peut être mise en oeuvre quel que soit le matériau semi-conducteur mis en oeuvre.

La figure 2 représente schématiquement en coupe le composant 30. La puce 32 est déposée sur un substrat 34 isolant, par exemple en céramique. Une métallisation recouvre sélectivement le substrat 34 et permet de raccorder électriquement la puce 32. La métallisation comprend ici deux parties 36 et 38. La partie 36 reçoit une broche 40 et la partie 38, une broche 42. La partie 36 s'étend sous la puce 32 et forme une première électrode du composant 30. La partie 38 est raccordée électriquement à la partie supérieure de la puce 32 au moyen d'une ou plusieurs jambes métalliques 44 formant une seconde électrode du composant 30. Un signal électrique peut circuler entre les deux broches 40 et 42 en fonction de l'état de la jonction dans le semi-conducteur formant la puce 32. Autrement dit, le composant 30 assure la commutation du signal électrique. Pour un composant à commutation naturelle, la différence de potentiel entre les deux broches 40 et 42 détermine l'état de la jonction et pour un composant à commutation commandée, une électrode de commande, non représentée sur la figure 2, permet le déclenchement de la commutation en faisant passer la jonction d'un état bloqué à un état passant. L'électrode de commande peut être reliée à une autre partie de la métallisation au moyen d'une autre jambe non située dans le plan de coupe de la figure 2.

Lors de son fonctionnement, le composant 30 dégage de la chaleur formant des pertes qu'il convient d'évacuer. Cette chaleur est principalement dégagée lors des commutations et lorsque la jonction est passante du fait de sa résistance interne. La chaleur générée dans la puce 32 est principalement drainée vers une semelle 46 par exemple réalisée en alliage métallique pour sa bonne capacité à conduire la chaleur. La semelle 46 peut par exemple être réalisée en alliage de cuivre ou d'aluminium. La semelle 46 peut être fixée à un radiateur, non représenté sur la figure 1 et permettant l'évacuation de la chaleur. L'évacuation peut se faire dans l'air ambiant par convection naturelle ou forcée. L'évacuation peut également se faire au moyen d'un de canaux circulant dans le radiateur et dans lesquels circule un fluide caloporteur. Le dimensionnement du radiateur est réalisé en fonction de la chaleur générée par le composant 30 lors de son utilisation et, pour une évacuation par convection, en fonction du milieu ambiant dans lequel baigne le radiateur. Il est courant de raccorder le radiateur à la masse électrique de l'équipement dans lequel le composant 30 et mis en oeuvre, par exemple un convertisseur 12 ou 14 tels que représentés sur la figure 1.

Comme évoqué plus haut, une capacité parasite se forme entre, d'une part la puce 32 et les parties 36 et 38 de la métallisation, et d'autre part la semelle 46, le substrat 34 formant un diélectrique de cette capacité parasite. Une autre capacité parasite se forme dans la puce 32 elle-même entre ses électrodes. Un courant de déplacement peut se former entre la jonction et la semelle 46 au travers de la capacité parasite. Ce courant peut être d'autant plus important que la vitesse de commutation augmente. En pratique, lors d'une commutation le courant circulant dans la jonction s'établit et s'interrompt en formant un échelon de courant dans un chronogramme. La demanderesse s'est aperçu que la répétition de ces échelons de courant génère des courants de fuite non négligeable circulant dans la masse électrique du système au travers de la capacité parasite du composant 30. L'invention cherche à limiter le courant circulant dans cette capacité parasite au moyen d'un filtre placé au plus près de la puce 32.

Selon l'invention, un plan conducteur 50 est disposé entre la semelle 46 et le substrat isolant 34. Le plan conducteur 50 est isolé électriquement d'une part de la puce 32 et des deux parties 36 et 38 de la métallisation et d'autre part de la semelle 46. Côté puce et métallisation, l'isolation du plan conducteur 50 est assurée par le substrat 34. Côté semelle 46, un film isolant 52 peut être interposé entre le plan conducteur 50 et la semelle 46. Le plan conducteur 50 peut être un film métallique par exemple en alliage de cuivre ou d'aluminium déposé sur la face du substrat 34 opposée à celle recevant la métallisation. Le plan conducteur 50 peut être réalisé dans tout autre type de matériaux conducteur comme par exemple à base de carbone. Le plan conducteur 50 peut être continu ou réalisé sous forme d'une grille possédant des ouvertures. La section des ouvertures est définie en fonction de la longueur d'onde des signaux parasites que l'on souhaite filtrer. Le film isolant 52 est bien entendu choisi pour assurer l'isolation électrique du plan conducteur 50 par rapport à la semelle 46. Il est avantageux de choisir un matériau possédant de bonnes propriétés de conduction thermiques pour éviter de freiner le transfert thermique de l'énergie calorifique dissipée par la puce 32 vers la semelle 46. A cet effet, on peut choisir un film isolant 52 à base de silicone ou de mica. L'isolation électrique du plan conducteur 50 par rapport à la semelle 46 peut également être assurée au moyen d'une couche par exemple de type vernis déposée sur le plan conducteur 50 en regard de la semelle 46. Le niveau d'isolation électrique entre le plan conducteur 50 et la semelle 46 est défini en fonction de la différence de potentiel pouvant exister entre le plan conducteur 50 et la semelle 46. Cette différence de potentiel sera précisée plus loin.

La figure 3 représente sous forme de schéma électronique le composant de commutation et les capacités parasites le reliant à la semelle 46. Le composant 30 est schématisé par un transistor. Comme évoqué plus haut d'autres composants de commutation peuvent être mis en oeuvre dans le cadre de l'invention. Une première capacité 54 est formée entre d'une part la puce 32 et sa métallisation et d'autre part le plan conducteur 50. Le substrat 34 frome le diélectrique de la capacité 54. Une seconde capacité 56 est formée entre le plan conducteur 50 et la semelle 46 qui est raccordée au potentiel d'une tension de référence telle qu'une masse électrique. Le film isolant 52 frome le diélectrique de la capacité 56. Vu la disposition du plan conducteur 50 entre le substrat 34 et la semelle 46, les deux capacités 54 et 56 peuvent être considérées comme raccordées en série.

Le composant 30 comprend en outre un contact électrique 58 configuré pour raccorder électriquement le plan conducteur 50. Le raccordement permet de réaliser un filtre amortisseur avec un composant électronique qui peut être extérieur au composant 30. Dans le schéma de la figure 3, le contact électrique 58 apparait au point commun des deux capacités 54 et 56. On peut par exemple raccorder le plan conducteur 50 à une prise de masse électrique du composant 30, par l'intermédiaire d'une résistance R. La prise de masse électrique 60 peut être raccordée à toute tension de référence. En raccordant la prise de masse électrique 60 au potentiel de la semelle 46, il y a peu de différence de potentiel aux bornes de la capacité 56. Il est ainsi possible de réduire l'épaisseur de l'isolation entre le plan conducteur 50 et la semelle 46. Le plan conducteur 50 pourrait être raccordé directement à une tension de référence. Les capacités parasites 54, 56 et les fils de connexion présentent déjà des résistances dont la valeur est typiquement de l'ordre de quelques milli-ohms. Couplé avec la capacité ajoutée par la présence du plan conducteur, cette résistance faible permet tout au plus de décaler la fréquence de résonnance parasite due aux capacités parasites du composant. L'amortissement est quasiment inexistant. Lors d'essais réalisés en interne, la demanderesse a constaté qu'une résistance d'au moins un Ohm donnait de bons résultats pour atténuer l'amplitude de certaines fréquences indésirables. Plus précisément, dans un onduleur sans le plan conducteur, des courants parasites circulant dans la masse et présentant des pics d'amplitude autour d'1 MHz ont été constatés. En mettant en oeuvre pour chaque composant de commutation de l'onduleur, un plan conducteur associé à une résistance d'un Ohm, les pics étaient atténués d'une vingtaine de dB.

De plus, en mettant en oeuvre un composant spécifique pour réaliser la résistance R, il est possible de le disposer à un emplacement choisi, afin que la dissipation de l'énergie du courant parasite puisse se faire par exemple sur un dissipateur thermique prévu à cet effet. La valeur de résistance du composant spécifique résistif R d'au moins un Ohm s'ajoute aux résistances des capacités parasites et des fils de connexion du plan conducteur 50 dans sa liaison à la tension de référence. Comme on l'a évoqué plus haut, la valeur de résistance du composant spécifique résistif R est de l'ordre de 1000 fois supérieure à celle des résistances des capacités parasites et des fils de connexion. En conséquence, la quasi-totalité de l'énergie du courant parasite est dissipée dans le composant spécifique. D'autres types de composants passifs ou même actifs peuvent être raccordés au contact électrique 58. On peut notamment raccorder entre le contact électrique 58 et une tension de référence en complément ou à la place de la résistance R des composants passifs de type capacité et/ou inductance. Dans le cas d'une inductance, lors d'essais réalisés en interne, la demanderesse a constaté qu'une valeur d'au moins 1µH donnait de bons résultats pour participer à l'amortissement du courant parasite. Dans le cas d'une inductance bobinée, on constate que sa valeur tend à diminuer lorsque la fréquence du courant augmente principalement à cause l'effet de peau. La valeur d'inductance de 1 µH au-delà de laquelle les résultats sont sensibles est mesurée à 10 kHz.

On peut aussi combiner un composant spécifique résistif R et un composant spécifique inductif L avec la capacité 56 pour obtenir un circuit amortisseur permettant à la fois de décaler la fréquence de résonnance et d'amortir les harmoniques du courant parasite.

Ces composants peuvent être disposés dans le boîtier du composant de commutation 30. Le contact électrique est alors un prolongement du plan conducteur débordant du substrat 34. Le contact électrique 58 peut aussi être une partie du plan conducteur 50. La résistance R ou, de façon plus générale, le composant raccordé au contact électrique 58 peut être monté en surface sur le substrat 34. Alternativement le contact électrique 58 peut sortir du composant et permettre à un concepteur d'équipements dans lequel on peut par exemple retrouver le redresseur 12, le convertisseur 14 et la charge 18 de choisir un composant à raccorder au contact électrique 58, composant adapté à l'équipement et aux courants parasites qu'il constate.

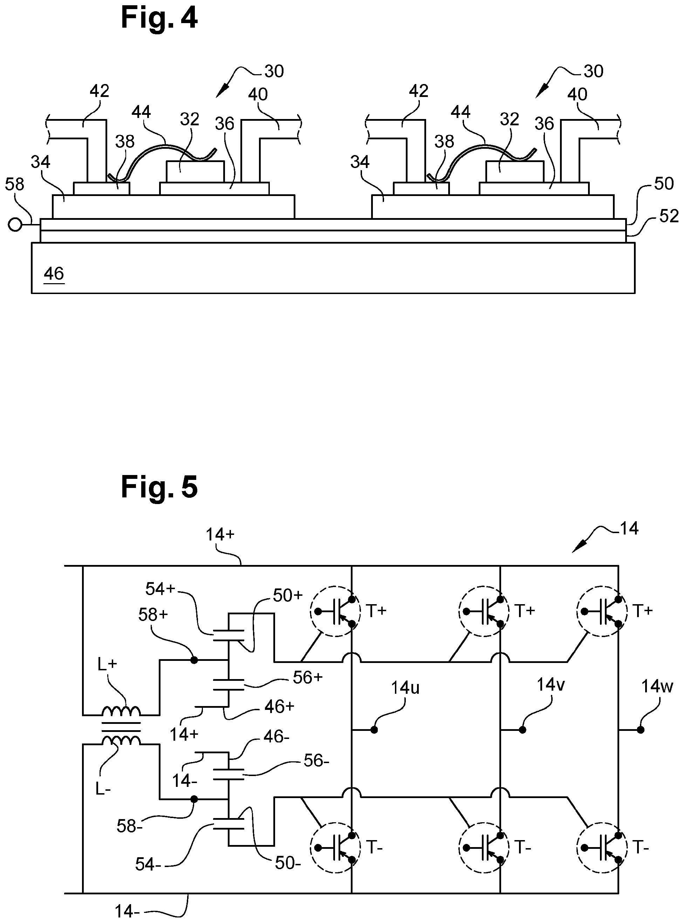

La figure 4 représente plusieurs composants de commutation possédant une semelle commune 46. La figure 5 représente sous forme de schéma électronique un convertisseur 14 de type onduleur triphasé dans lequel l'invention est mise en oeuvre. Comme indiqué plus haut, l'invention peut être mise en oeuvre dans tout type de convertisseur, quel que soit le nombre de composant de commutation. Les figures 4 et 5 s'intéressent aux convertisseurs mettant en oeuvre plusieurs composants de commutation. Dans ces convertisseurs, il est avantageux de mutualiser le plan conducteur qui devient commun aux différents composants de commutation ou tout au moins à un groupe de plusieurs composants de commutation du convertisseur. La figure 5 décrit un onduleur. Il est bien entendu que la mutualisation d'un plan conducteur peut s'appliquer à tout type de convertisseur, par exemple dans un redresseur.

La figure 4 représente deux composants de commutation 30. A la différence du composant 30 décrit de façon isolé à l'aide de la figure 2, sur la figure 4, la semelle 46 et le plan conducteur 50 sont communs aux deux composants de commutation 30. Sur la figure 4, le film isolant 52 est également commun aux deux composants de commutation 30. Comme précédemment, tout autre moyen d'isolation du plan conducteur 50 par rapport à la semelle 46 reste possible. Le contact électrique 58 est associé au plan conducteur 50 et est également commun aux deux composants de commutation 30.

L'onduleur 14, représenté schématiquement sur la figure 5, permet de fournir trois phases 14u, 14v et 14w en tension alternative à partir de deux tensions continue 14+ et 14-. L'onduleur 14 comprend deux groupes de composants de commutation. Le premier groupe comprend des transistors repérés T+ et permettant de commuter la tension continue 14+. Chaque transistor T+ du premier groupe contribue à la fourniture d'une des phases 14u, 14v et 14w. De même, le second groupe comprend des transistors repérés T- et permettant de commuter la tension continue 14-. Chaque transistor T- du second groupe contribue à la fourniture d'une des phases 14u, 14v et 14w.

Les trois transistors T+ du premier groupe possèdent un plan conducteur commun 50+ et les trois transistors T- du second groupe possèdent un plan conducteur commun 50-. Le convertisseur 14 peut ne comprendre qu'une seule semelle commune à tous les transistors T+ et T-. la semelle est par exemple raccordée à une masse électrique d'un équipement dans lequel le convertisseur 14 est intégré. Alternativement, il est possible de prévoir deux semelles distinctes 46+ et 46-, une par groupe de transistors T+ d'une part et T- d'autre part. Les deux semelles 46+ et 46- peuvent être raccordées à une même tension de référence ou à deux tensions de référence distinctes. Par exemple, la semelle 46+ associée aux transistors T+ peut être raccordée à la tension continue 14+ et la semelle 46-associée aux transistors T- peut être raccordée à la tension continue 14- comme illustré sur la figure 5. Il est aussi possible de raccorder la semelle 46+ à la tension continue 14- et la semelle 46- à la tension continue 14+.

La présence de deux plans conducteurs 50+ et 50- entraine la présence de deux capacités, respectivement 54+ et 54-, d'une part entre les transistors T+ le plan conducteur 50+ et d'autre part entre les transistors T- le plan conducteur 50-. Associé à chaque plan conducteur 50+ et 50-, on retrouve un contact électrique 58, respectivement 58+ et 58-. Sur la figure 5, on retrouve deux capacités 56+ et 56-formée entre le plan conducteur, respectivement 50+ et 50- et leur semelle correspondante ou à la semelle commune à tous les transistors T+ et T-.

Il est aisé de transposer le schéma décrit de la figure 5 à d'autres types de convertisseur, par exemple au redresseur 12 en pont complet, c'est à dire comprenant quatre diodes de redressement. On peut y définir un premier groupe de deux diodes commutant une des phases d'une tension alternative et un second groupe de deux diodes commutant l'autre phase de la tension alternative. Dans un tel redresseur, un premier plan conducteur peut être commun au premier groupe de diodes et un second plan conducteur peut être commun au second groupe de diodes.

On a vu, à l'aide de la figure 3, que le plan conducteur pouvait être raccordé à une tension de référence par l'intermédiaire de tout type de composant, actif ou passif. La tension de référence peut être par exemple, la masse électrique 60 de l'équipement dans lequel l'onduleur 14 est mis en oeuvre. La tension de référence peut aussi est l'une des tensions continues 14+ ou 14-. Il est également possible de dissocier la tension de référence. Plus précisément, le contact électrique 58+ peut être raccordé, directement ou par l'intermédiaire de composants de type R, L, C, à la tension continue 14+. Par ailleurs, le contact électrique 58- peut être raccordé, directement ou par l'intermédiaire de composants de type R, L, C, à la tension continue 14-. Dans l'onduleur 14, le plan conducteur 50+ est raccordé à une tension de référence par l'intermédiaire d'une inductance L+ et le plan conducteur 50- est raccordé à la même tension de référence 60 par l'intermédiaire d'une inductance L-. Sur la figure 5, les deux inductances L+ et L- possèdent un point commun raccordé à une même tension de référence. Alternativement, il est possible de dissocier les tensions de référence auxquelles sont raccordées les deux inductances L+ et L-. Par exemple, l'inductance L+ peut être raccordée à la tension continue 14+ et l'inductance L- peut être raccordée à la tension continue 14-.

Les deux inductances L+ et L- peuvent être couplées par exemple en les enroulant sur un même noyau magnétique. En complément des deux inductances L+ et L-, il est possible d'ajouter d'autres composants passifs ou actifs. Comme évoqué plus haut, il est possible de raccorder entre le point commun des deux inductances, ou entre chaque inductance et la tension de référence respective, des composants passifs de type résistance et/ou capacité et/ou inductance.

La mise en oeuvre de deux inductances couplées en mode commun peut être réalisée pour tout autre type de convertisseur et notamment pour le redresseur (12).

## Revendications

1. Composant configuré pour commuter un signal électrique, le composant comprenant :
- un substrat isolant (34) portant une puce semi-conductrice (32) assurant la commutation du signal,
- une semelle (46) sur laquelle est fixé le substrat (34), la semelle (46) étant configurée pour évacuer de la chaleur émise lors de commutation du composant (30 ; T+, T-),
- un plan conducteur (50 ; 50+,50-) disposé entre la semelle (46) et le substrat isolant, (34) le plan conducteur (50 ; 50+, 50-) étant isolé électriquement de la semelle (46),
**caractérisé par le fait qu'**il comprend en outre :
- un composant spécifique (R, L+, L-) présentant une impédance d'au moins 1 Ohm et/ou une inductance d'au moins 1 µH, par l'intermédiaire duquel le plan conducteur (50 ; 50+, 50-) est raccordé à une tension de référence (14+, 14- ; 60).

2. Composant selon la revendication 1, dans lequel le composant spécifique est une résistance (R) d'au moins 1 Ohm.

3. Convertisseur statique comprenant plusieurs composants (T+, T-) selon l'une des revendications précédentes dans lequel les plans conducteurs (50+,50-) et les semelles (46) de chaque composant (T+, T-) sont commun.

4. Convertisseur selon la revendication 3, comprenant un premier groupe (T+) et un second groupe (T-) de composants selon l'une des revendications 1 ou 2, dans lequel dans chacun des groupes de composants, les plans conducteurs (50+,50-) et les semelles (46+, 46-) de chaque composant (T+, T-) sont commun, dans lequel, le plan conducteur (50+) du premier groupe (T+) est raccordé à une première tension de référence (14+) par l'intermédiaire d'une première inductance (L+) et le plan conducteur (50-) du second groupe (T-) est raccordé à une seconde tension de référence (14-) par l'intermédiaire d'une seconde inductance (L-), et dans lequel les deux inductances (L+, L-) sont couplées et ont une impédance d'au moins 1 µH.

## Patentansprüche

1. Bauelement, das dafür konfiguriert ist, ein elektrisches Signal zu schalten, wobei das Bauelement Folgendes umfasst:
- ein isolierendes Substrat (34), das einen Halbleiterchip (32) trägt, der das Schalten des Signals gewährleistet,
- eine Grundplatte (46), auf der das Substrat (34) befestigt ist, wobei die Grundplatte (46) dafür konfiguriert ist, bei der Schaltung des Bauelements (30; T+, T-) ausgestrahlte Wärme abzuführen,
- eine Leiterfläche (50; 50+, 50-), die zwischen der Grundplatte (46) und dem isolierenden Substrat (34) angeordnet ist, wobei die Leiterfläche (50; 50+, 50-) elektrisch von der Grundplatte (46) isoliert ist,
**dadurch gekennzeichnet, dass** es ferner Folgendes umfasst:
- ein spezifisches Bauelement (R, L+, L-), das eine Impedanz von mindestens 1 Ohm und/oder eine Induktivität von mindestens 1 µH aufweist, über welches die Leiterfläche (50; 50+, 50-) an eine Bezugsspannung (14+, 14-; 60) angeschlossen ist.

2. Bauelement nach Anspruch 1, wobei das spezifische Bauelement ein Widerstand (R) von mindestens 1 Ohm ist.

3. Statischer Wandler, umfassend mehrere Bauelemente (T+, T-) nach einem der vorhergehenden Ansprüche, wobei die Leiterflächen (50+, 50-) und die Grundplatten (46) von jedem Bauelement (T+, T-) gemeinsam genutzt werden.

4. Wandler nach Anspruch 3, umfassend eine erste Gruppe (T+) und eine zweite Gruppe (T-) von Bauelementen nach einem der Ansprüche 1 oder 2, wobei in jeder der Gruppen von Bauelementen die Leiterflächen (50+, 50-) und die Grundplatten (46+, 46-) von jedem Bauelement (T+, T-) gemeinsam genutzt werden, wobei die Leiterfläche (50+) der ersten Gruppe (T+) über einen ersten Induktor (L+) an eine erste Bezugsspannung (14+) angeschlossen ist und die Leiterfläche (50-) der zweiten Gruppe (T-) über einen zweiten Induktor (L-) an eine zweite Bezugsspannung (14-) angeschlossen ist, und wobei die beiden Induktoren (L+, L-) gekoppelt sind und eine Impedanz von mindestens 1 µH aufweisen.

## Claims

1. A component which is configured to switch an electrical signal, the component comprising:
- an insulating substrate (34) bearing a semiconductor chip (32) which ensures switching of the signal;
- a sole plate (46) on which the substrate (34) is secured, the sole plate (46) being configured to discharge heat emitted during switching of the component (30; T+, T-);
- a conductive plane (50; 50+, 50-) positioned between the sole plate (46) and the insulating substrate (34), the conductive plane (50; 50+, 50-) being electrically insulated against the sole plate (46),
**characterised in that** it further comprises:
- a specific component (R, L+, L-) with an impedance of at least 1 Ohm and/or an inductance of at least 1 µH, by means of which the conductive plane (50; 50+, 50-) is connected to a reference voltage (14+, 14-; 60).

2. The component according to claim 1, wherein the specific component is a resistor (R) of at least 1 Ohm.

3. A static converter comprising multiple components (T+, T-) according to any one of the preceding claims, wherein the conductive planes (50+, 50-) and the sole plates (46) of each component (T+, T-) are shared.

4. The converter according to claim 3, comprising a first group (T+) and a second group (T-) of components according to any one of claims 1 or 2, wherein, in each of the groups of components, the conductive planes (50+, 50-) and the sole plates (46+, 46-) of each component (T+, T-) are shared, wherein the conductive plane (50+) of the first group (T+) is connected to a first reference voltage (14+) by means of a first inductor (L+), and the conductive plane (50-) of the second group (T-) is connected to a second reference voltage (14-) by means of a second inductor (L-), and wherein the two inductors (L+, L-) are coupled, and have an impedance of at least 1 µH.
